Europäisches Patentamt

European Patent Office

Office européen des brevets

(11) Publication number: **0 237 697 B1**

(12) # EUROPEAN PATENT SPECIFICATION

(45) Date of publication of patent specification: **29.12.93**  (51) Int. Cl.⁵: **G01R 1/04**, G01D 11/30, G12B 5/00, G01R 31/28

(21) Application number: **87100158.2**

(22) Date of filing: **16.08.83**

(60) Publication number of the earlier application in accordance with Art.76 EPC: **0 102 217**

(54) Electronic test head positioner for test systems.

(30) Priority: **25.08.82 US 411311**
**11.08.83 US 522635**

(43) Date of publication of application:
**23.09.87 Bulletin 87/39**

(45) Publication of the grant of the patent:
**29.12.93 Bulletin 93/52**

(84) Designated Contracting States:
**AT BE CH DE FR GB IT LI LU NL SE**

(56) References cited:
**US-A- 4 132 318**
**US-A- 4 264 266**

(73) Proprietor: **InTest Corporation**
**12 Springdale Road**
**Cherry Hill New Jersey 08003(US)**

(72) Inventor: **Smith, Nathan R.**
**114 Nanticoke Court**
**Vincentown New Jersey 08088(US)**

(74) Representative: **Pacitti, Pierpaolo A.M.E. et al**
**Murgitroyd and Company**
**373 Scotland Street**
**Glasgow G5 8OA (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services
(3. 10/3.6/3.3. 1)

**Description**

This invention relates to the field of art of electronic test head positioners.

In the automatic testing of integrated circuits (IC) and other electronic devices, special device handlers have been used which place the device to be tested in position. The electronic testing itself is provided by a large and expensive automatic testing system which includes a test head which has been required to connect to and dock with the device handler. In such testing systems, the test head has been usually very heavy in the order of 34 to 136 kilograms. The reason for this heaviness is that the test head uses high speed electronic timing signals so that the electronic circuits must be located as close as possible to the device under test Accordingly, the test head has been densely packaged with electronic circuits in order to achieve the high speed testing of the sophisticated devices.

The prior art has left much to be desired in providing a manipulator or positioner to easily move the heavy test head accurately into position with respect to the device handler mechanism. In some prior positioners the test head has been positioned by means of lead screws and rotating and sliding mechanisms each movable one at a time. These prior systems left much to be desired in that they did not provide all of the degrees of freedom necessary for easy and accurate docking with the handler. The user has had to move the heavy device handler or the heavy positioner itself in order to provide alignment. Other prior art manipulating systems have used motors to drive the lead screws in the up/down direction. Such a motor driven lead screw or even a hand driven one provides the possibility of damaging either the test head socket connections or the connections which are on the device handler due to overstressing.

Another disadvantage of the prior art systems is that they are large and take up a considerable amount of floor space which is at a premium in test facilities. A further difficulty of large prior systems has involved the cable which connects the test system to the test head which is usually short, cumbersome and fragile. Accordingly as a result of their size and construction, prior systems could not be moved sufficiently close to the test system.

For purposes of considering patentability, a brief patentability search was conducted. The patents identified to be of possible interest in the search were:

| Patent No. | Inventor |
| --- | --- |
| 4,199,294 | Streck et al. |
| 4,062,455 | Carl Flatau |
| 4,132,318 | Wang et al. |
| 3,873,148 | Robert Kennicuit |
| 4,076,131 | Dahlstrom et al. |
| 4,188,166 | Moreau et al. |
| 4,273,506 | Thomson et al. |
| 4,299,529 | Inaba et al. |

| Patent No. | Inventor |
| --- | --- |
| 4,264,266 | Hans Trechsel |
| 3,791,052 | Cornelis Van Der Lely |
| 3,826,383 | Hans Richter |
| 4,303,368 | Dent et al. |

Accordingly, an object of the present invention is an electronic test head positioner that has six degrees of freedom and provides a substantially weightless condition to the test head which may be manipulated by hand for easy and accurate docking and undocking of the test head with the device handler.

Another object of the invention is an electronic test head positioner formed by a column rising vertically from a base which takes little room on the floor with respect to the test system.

A further object is a system for docking and undocking an electronic test head with respect to an electronic device handler.

This object is achieved by a system according to claim 1 or claim 2.

Brief Description of the Drawings

Figs. 1-3 are perspective views of a test head positioner system;

Fig. 4 is an elevational sectional view of Fig. 3;

Fig. 5A is a diagrammatic view of the system of Figs. 1-3 showing the docking of a test head with a mechanism plate of a handler;

Figs. 5B-C is a perspective view and an elevational sectional view of the detailed structure of the mechanism plate and test head;

Fig. 6 diagrammatically shows the six degrees of freedom of the system of Figs. 1-3;

Description of the Preferred Embodiment

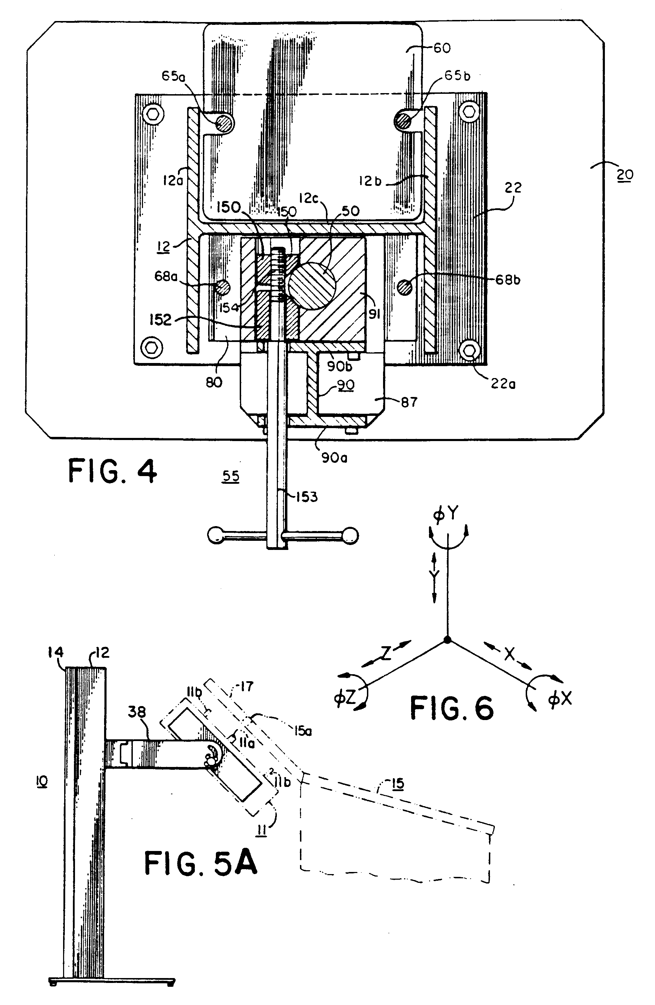

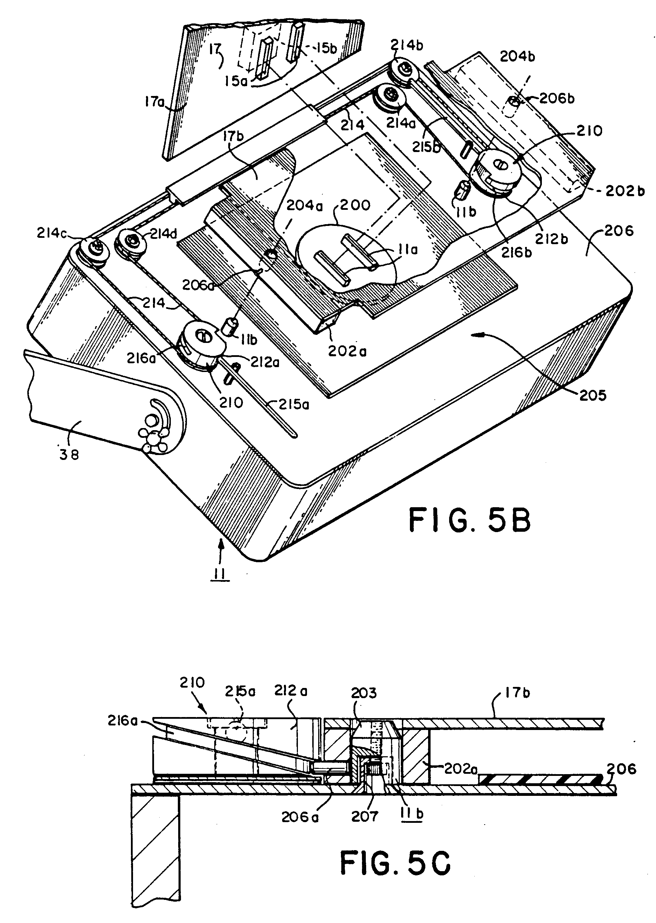

Referring now to Fig. 5A, there is shown a test head positioner system 10 in accordance with the invention. As shown, positioner system 10 carries a test head 11 for a test system for docking with a mechanism plate 17 of an integrated circuit handler 15. It will be understood that other electronic devices may be handled by device handler such as transistors, chips or dies, etc. In operation, positioner system 10 is moved manually in a substantially weightless condition to manipulate the heavy test head 11 accurately and precisely and dock it into the mechanism plate 17. In docking, location pins 11b are inserted into corresponding openings in plate 17 and test connector 11a enters and mates with a connector 15a for a device 15b to be tested. The position of test head 11 may be accurately manipulated in a substantially weightless condition to another position with six degrees of freedom substantially extensible in the horizontal plane to dock with other mechanism plates in any position. For example, mechanism plates for probers or handlers may be anywhere from a horizontal plane to a vertical plane.

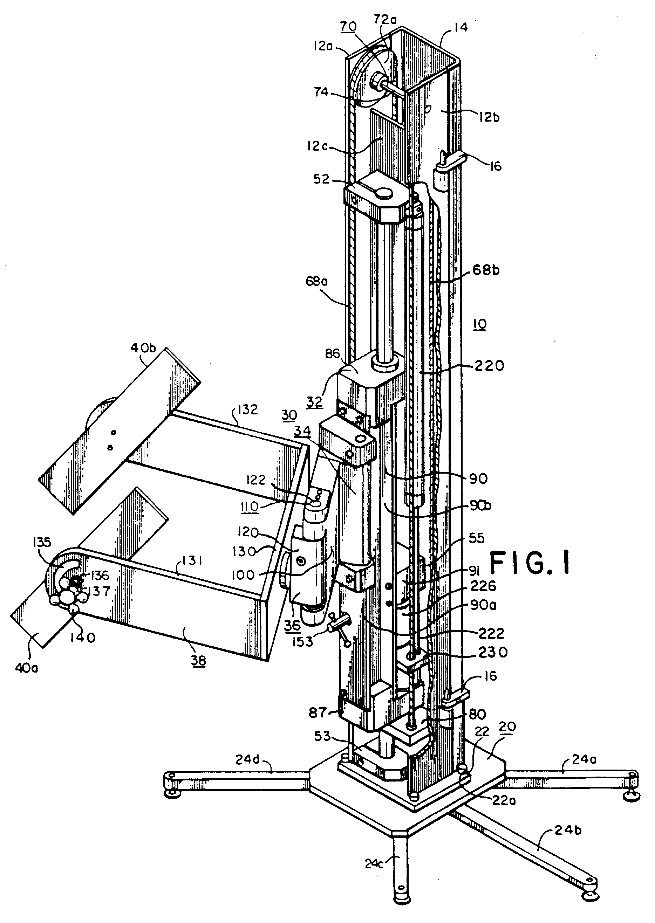

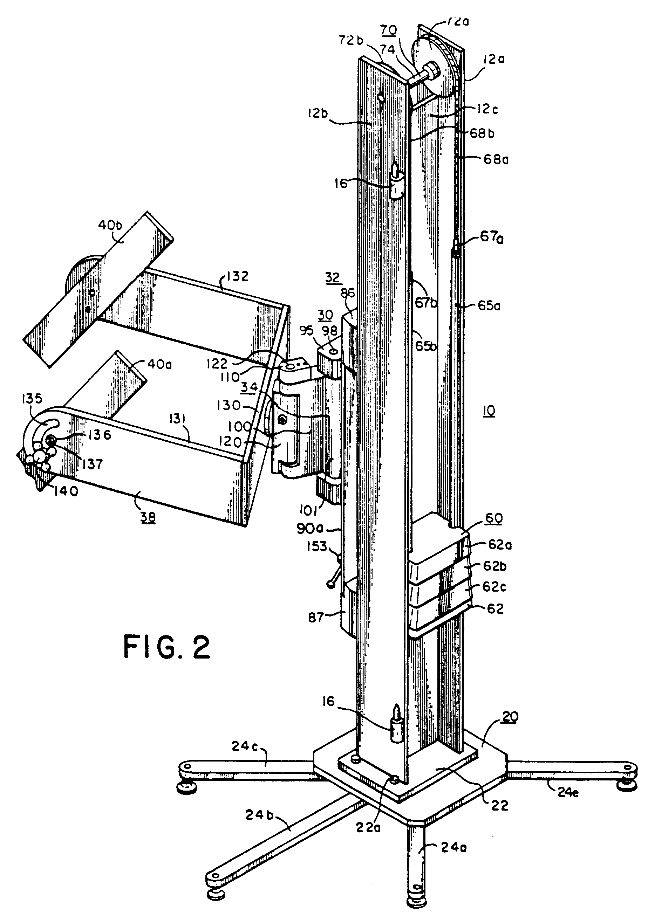

The details of system 10 are shown in Figs. 1-3 in which an H-shaped beam forms a vertical column 12. Column 12 has opposing walls 12a,b with a flange 12c connecting the two walls together. Column 12 is supported at its bottom by a base assembly 20 having a base plate 22 and outwardly extending legs 24a-e. Column 12 is secured to plate 22 by bolts 22a for example. The rear of column 12 is closed by a U-shaped door 14 hinged to wall 12b by way of hinges 16.

Test head 11 is supported and manipulated in its docking by a positioner arm assembly 30 which moves vertically on a main shaft 50. Assembly 30 comprises a main arm assembly 32, a forearm assembly 34, a wrist joint assembly 36, a cradle assembly 38 and test head adapter plates 40a,b. Main shaft 50 is secured by opposing pillow blocks 52,53.

Positioner arm assembly 30 is counterbalanced to ride vertically on main shaft 50 by a counter weight assembly 60 having a weight carriage 62 which moves vertically in either direction within the rear section of column 12. Carriage 62 has vertically extending carriage shafts 65a,b secured thereto and carries removable weights 62a-c. Weights 62a-c exactly counterbalance the weight of assembly 30 and test head 11 so that they are substantially weightless.

The upper ends of shafts 65a,b threadedly receive members 67a,b swaged to respective ends of cables 68a,b received within grooves of pulleys 72a,b of assembly 70. Shaft 74 permits the rotation of pulleys 72a,b and the shaft is received at an upper end section of column 12. Cables 68a,b extend downwardly along the inner surface of walls 12a,b through openings in a plate 230 and are securely fastened by way of swaged members to a lift block 80 positioned under main arm assembly 32. Block 80 has an opening for receiving shaft 50 and the block slides along web 12c and is thus prevented from rotating around shaft 50.

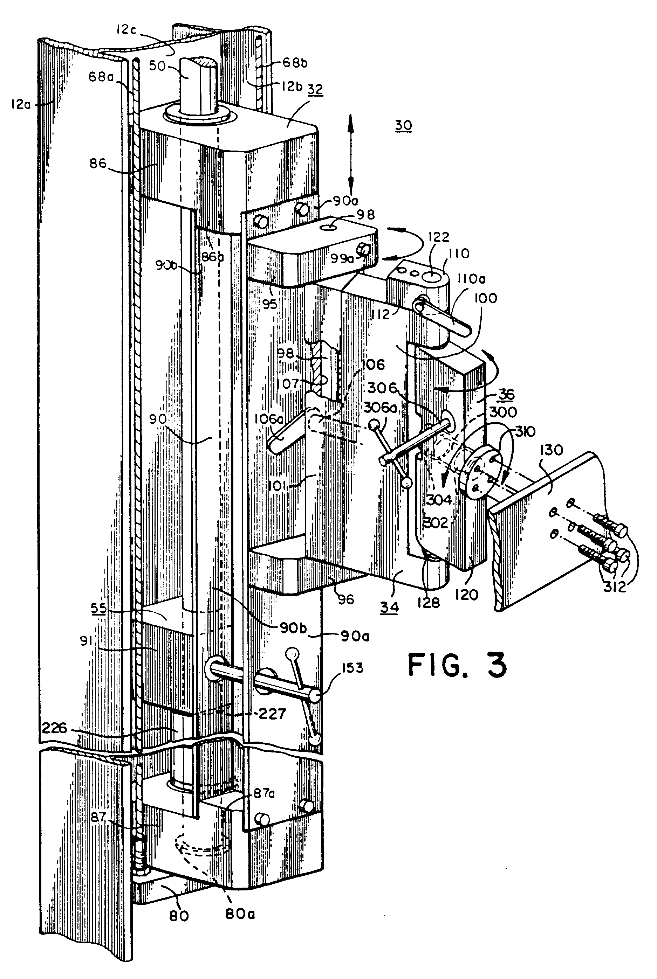

As shown in Fig 3, main arm assembly 32 includes an upper bearing block 86 and a lower bearing block 87 carried by block 80. A main shaft thrust bearing 80a is provided between blocks 80,87. Blocks 86,87 have respective lower extending and upper extending sections 86a, 87a and as shown engage an I beam 90. Specifically, a front wall 90a of I beam 90 is secured to front faces of blocks 86,87 while a rear section 90b of I beam 90 is secured to sections 86a, 87a. The vertical and rotational movements of assembly 32 may be temporarily locked in any position by means of a lock 55 formed in a block 91 as later described in detail A sleeve 226 concentric with shaft 50 is secured between blocks 87, 91 having inner linear bearings 228 which permit the sleeve to travel upwardly and downwardly on shaft 50 Further, sleeve 226 has thrust bearings 227. In this way a unitary main arm assembly 32 is formed which 15 adapted to have vertical movement and rotational movement (about a vertical axis) on a vertical shaft 50.

To provide velocity sensitive viscous damping for assembly 32, a fluid cylinder 220 has one end fixed to pillow block 52 and the other end to plate 230 secured to the outer surface of sleeve 226. Cylinder 220 prevents rapid vertical movement of arm assembly 30 as a safety feature for operating personnel and to prevent damage to the handler and test head. Cylinder 220 may be a Bimba model 0920-DP, Bimba Manufacturing Co., Monea, Illinois.

Secured to front face 90a are a pair of pillow blocks 95, 96 of forearm assembly 34. A vertical shaft 98 extends through pillow blocks 95, 96. Forearm assembly 34 further includes a forearm 100 having a rear section 101 which is bolted to forearm 100 by means of bolts. Shaft 98 extends through vertical opening 107 in section 101 with needle bearings at either end and a thrust bearing between section 101 and pillow block 96. Forearm assembly 34 may be temporarily fixed in its rotational position about a vertical axis by means of a forearm lock assembly 106.

It will be understood that forearm assembly 34 may be effectively turned 180° while maintaining all the other elements in their original positions. In this manner, rear section 101 extends to the left as compared to the right as shown in Fig. 3.

Forearm 100 has a front "C" shaped section which rotatively receives an attachment member 120 of wrist joint assembly 36. Member 120 rotates with respect to forearm 100 by way of vertical upper and lower pivot pins 122. Needle bearings are provided for the rotation of pins 122 in forearm 100 and a thrust bearing 128 is provided between member 120 and forearm 100. Member 120 may be temporarily prevented from rotation with respect to assembly 34 by means of a wrist joint lock assembly 110 which is formed within a block 112 secured to the upper surface of forearm 100.

Member 120 has a longitudinal opening for receiving a horizontally extending shaft 300 which is rotated within needle bearings 302 and 304 secured to member 120. Shaft 300 at its outer end is welded to a connecting hub 310 for threadedly receiving cap screws 312 to rigidly secure back plate 130 of cradle assembly 38.

Cradle assembly 38 is formed by three walls 130-132 welded together to form a U-shaped holder for the test head. Shaft 300 is effective to allow the rotation of assembly 38 about a horizontal axis and assembly 38 may be secured in position by tightening of cradle lock assembly 306 which is similar to assembly 55.

Walls 131, 132 receive test head adapter plates 40a,b and allow these plates to rotate with respect to the walls and then to be rigidly fixed in position. Since the structure of both plates 40a,b are the same only one of them need be described. Arm 131 has within an end section a circular groove 135 and an opening 136 for receiving a shoulder screw 137. A lock knob 140 is threaded into plate 40a and moves about circular groove 135 in conventional manner. In this way, by tightening lock knob 140, plate 40a is rigidly secured with respect to wall 131.

It will now be understood that test head positioner system 10 simultaneously positions in six degrees of freedom, X, Y, Z, $\theta_X$, $\theta_Y$, $\theta_Z$. As shown in Fig. 6, it is important for the proper docking of test head 11 that the test connector 11a have that six degrees of freedom so that it can accurately and effortlessly be positionied with respect to the device to be tested, 15b for example. If the Y direction were considered to be the vertical or up/down direction then the movement of assembly 32 vertically with respect to shaft 50 provides the Y direction of freedom. $\theta_Y$ freedom, which is the rotation about the Y axis is then provided by simultaneous rotation of all of the joints about vertical axes 50, 98 and 122.

If the X direction were considered to the left to right direction, then that freedom is provided by pivots 50, 98 and 122 in the same manner a $\theta_y$. The $\theta_x$ freedom is provided by shoulder screw pivot 137. With respect to Z movement which may be considered to be the in and out movement, such freedom is provided by pivot shafts 50, 98 and 122 in the same way as $\theta_y$, $\theta_z$ is then provided by the pivoting of shaft 300.

Referring now to Fig. 4, there is shown a main arm assembly lock-55 which comprises as a conventional wedge lock system. Specifically, two wedges 150 and 152 are provided on either side of shaft 50 and are threadedly engaged by threads 154 of a lock handle 153. By turning lock handle 153 clockwise, wedge members 150, 152 are brought together and apply pressure onto shaft 50 and this way prevent rotation of block 91 about shaft 50 and also prevent a vertical movement of block 91 and the entire assembly 30. Similar lock assemblies are provided for forearm lock assembly 106, wrist joint lock assembly 110 and cradle lock assembly 306 which have turning arms 106a, 110a, 306a respectively.

Referring now to Figs. 5B,C, there is shown the details of mechanism plate 17 and test head 11. Specifically, mechanism 17 comprises a handler back plate 17a and a docking gusset assembly 17b. Plate 17a carries a device 15b to be tested which is electrically connected through movable contacts to male connectors 15a fixed to the back plane of plate 17a. Assembly 17b has an opening 200 to allow access to connectors 15a and effectively provides the back plane with gussets or blocks 202a,b by bolting assembly 17b to the back plane of plate 17a. It will be understood that similar gussets may, in a further embodiment, be mounted directly to the back plane.

Each of gussets 202a,b has a centrally located guide opening 204a,b and are adapted to receive guide or location pins 11b of test head 11. Specifically, test head 11 has a docking assembly 205 and test connectors 11a which are mounted on a test head face plate 206. Guide pins 11b are effective to accurately locate connectors 11a with handler connectors 15a.

It will be understood that connectors 11a, 15a are very fragile and must be mated with great accuracy to avoid damage. This is particularly a problem in view of the weight and mass of test head 15. Accordingly, guide pins 11b and blocks 202a,b are effective to keep the connectors 11a, 15a separated from each other until the pins 11b are actually received in guide openings 204a,b which ensures alignment and positive precise connection of connectors 11a, 15a. When pins 11b are aligned in the openings, it is then necessary to pull connectors 11a, 15a together. This is accomplished by means of a cam assembly 210 mounted on plate 206 which receives cam follower pins 206a,b which extend outwardly from blocks 202a,b. Assembly 210 comprises a pair of cylindrical cams 212a,b journaled at their centers to fixed pivots and which synchronously operate by way of an endless cable 214. Each of the cams has a lower groove for receiving cable 214 which is tautly coupled between the cams by way of pulleys 214a-d, as shown. Each cam 212a,b has an outwardly extending handle 215a,b so that rotation of either handles operates both cams in synchronism with a mechanical advantage of, for example, 5:1.

Each cam 212a,b has a side helical groove 216a,b with an upper cut-out on the upper face for respectively receiving pins 206a,b when pins 11b are in openings 204a,b. Upon turning of one of the handles 215a,b the cams operate in synchronism to pull test head 11 into the plane of handler mechanism plate 17, thereby bringing both connectors 11a, 15a together into mating relationship. After mating, many devices 15b may then be tested by the handler system. In order to change test configurations, it is then necessary to disconnect connectors 11a, 15a and then remove the handler from the test head. Accordingly, one of the handles is operated to pull plate 17a from plate 206 thereby disconnecting connector 11a from 15a.

In this manner, by rotary motion to cam assembly 210 there is produced linear motion between plates 17a, 206 for the required docking and undocking force.

Each of the guide pins 11b is calibratable and includes an outer pin housing 203 having an inner chamber which receives a guide pin mount 207 having an outer diameter substantially less than the inner diameter of the chamber. Mount 207 has an inner chamber for receiving a cap screw 209 which extends through an opening which provides substantial clearance. Thus screw 209 may be loosened so that housing 203 may be precisely aligned on plate 206.

## Claims

1. A system for docking and undocking an electronic test head (11) with respect to an electronic device handler (15) with the test head and the device handler having respective first and second electrical contact means (11a,15a) adapted to mate with each other, characterized in that there is provided:

   at least first and second alignment pins (11b,11b) rigidly secured to the device handler (15) on either side of the second electrical contact means (15a),

   at least first and second alignment bars (202a,b) having respective first and second guide openings (204a,b) and rigidly secured to the test head (11) on either side of the first electrical contact means (11a),

   at least first and second alignment structures (210,210), each selectively spaced with respect to the first and second alignment pins;

   the first and second guide openings (204a,b) precisely aligned with respect to and for receiving respective first and second alignment pins (11b,11b) for accurate mating of the first and second electrical contact means (11a,15a),

   the first and second alignment structures (210,210) positioned and the first and second alignment pins positioned so that they contact respective first and second alignment bars as the electronic test head (11) is moved with respect to the electronic device handler (15) in an attempt to dock them together until the first and second alignment pins are received in the respective first and second guide openings for precise alignment of the alignment bars between the alignment structures and the alignment pins and thereby to allow the docking of the electronic test head (11) and the electronic device handler (15) and the mating of the first and second contact means (11a,15a), and

   the height of the first and second alignment structures and the height of the first and second alignment pins being sufficient to prevent engagement of the first contact means with the second

EP 0 237 697 B1

contact means until said precise alignment is achieved to avoid damage to the first and second contact means (11a,15a).

2. A system for docking and undocking an electronic test head (11) with respect to an electronic device handler (15) with the test head and the device handler having respective first and second electrical contact means (11a,15a) adapted to mate with each other, characterized in that there is provided:

at least first and second alignment bars (202a,b) having respective first and second guide openings (204a,b) and rigidly secured to the device handler (15) on either side of the second electrical contact means (15a),

at least first and second alignment pins (11b,11b) rigidly secured to the test head on either side of the first electrical contact means (11a),

at least first and second alignment structures (210,210), each selectively spaced with respect to the first and second alignment pins;

the first and second guide openings (204a,b) precisely aligned with respect to and for receiving respective first and second alignment pins (11b,11b) for accurate mating of the first and second electrical contact means (11a,15a),

the first and second alignment structures positioned and the first and second alignment pins positioned so that they contact respective first and second alignment bars as the electronic test head (11) is moved with respect to the electronic device handler (15) in an attempt to dock them together until the first and second alignment pins are received in the respective first and second guide openings for precise alignment of the alignment bars between the alignment structures and the alignment pins and thereby to allow the docking of the electronic test head (11) and the electronic device handler (15) and the mating of the first and second contact means (11a,15a), and

the height of the first and second alignment structures and the height of the first and second alignment pins being sufficient to prevent engagement of the first contact means with the second contact means until said precise alignment is achieved to avoid damage to the first and second contact means (11a,15a).

3. The system of claims 1 or 2 in which said first and second alignment bars (202a,b) each have an outer, elongated side surface,

the first alignment pin (11b) being separated from the first alignment structure (212a) for receiving in a close spacing therebetween the first alignment bar (202a) between the respective side surface and the first guide opening,

the second alignment pin (11b) being spaced from the second alignment structure (212b) for receiving in a close spacing therebetween the second alignment bar (202b) between the respective side surface and the second guide opening.

4. The system of claims 1 or 2 in which the height of the first and second alignment pins (11b) and the respective first and second alignment structures (212a,b) upper surfaces are substantially the same.

5. The system of claim 1 in which the first and second alignment structures (210,210) include a camming assembly (210,210) for pulling together and pushing apart the head (11) and the handler (15), said camming assembly includes at least two cams (212a,b) coupled to the device handler and adapted to receive cam follower pins (206a,b) secured to the test head.

6. The system of claim 2 in which the first and second alignment structurs (210,210) include a camming assembly (210,210) for pulling together and pushing apart the head (11) and the handler (15), said camming assembly includes at least two cams (212a,b) coupled to the test head and adapted to receive cam follower pins (206a,b) secured to the handler.

7. The system of claims 5 or 6 in which said two cams (212a,b) have helical grooves (216a,b) for receiving cam follower pins, and cable means (214) for coupling the cams together so that they turn in synchronism.

8. The system of claims 1 or 2 in which at least one of said alignment pins (11b) includes means for adjusting (207) the position of the alignment pin.

6

EP 0 237 697 B1

**Patentansprüche**

1. Anlage zum Andocken und Entdocken eines elektronischen Testkopfes (11) mit Bezug auf einen elektronischen Gerätesekundanten (15), wobei der Testkopf und der Gerätesekundant erste und zweite elektrische Kontaktmittel (11a, 15a) aufweisen, die für ein wechselseitiges Zusammenpassen ausgebildet sind, gekennzeichnet durch das Vorsehen von:
wenigstens ersten und zweiten Paßstiften (11b, 11b), die an dem Gerätesekundanten (15) an jeder Seite der zweiten elektrischen Kontaktmittel (15a) starr befestigt sind,
wenigstens erste und zweite Ausrichtstäbe (202a, b), die erste und zweite Führungsöffnungen (204a, b) haben und an dem Testkopf (11) auf jeder Seite der ersten elektrischen Kontaktmittel (11a) starr befestigt sind,
wenigstens erste und zweite Ausrichtanordnungen (210, 210), die mit Bezug auf die ersten und zweiten Paßstifte jeweils selektiv beabstandet sind;
wobei die ersten und zweiten Führungsöffnungen (204a, b) mit Bezug auf die und für eine Aufnahme der betreffenden ersten und zweiten Paßstifte (11b, 11b) präzise ausgerichtet sind, um mit den ersten und zweiten elektrischen Kontaktmitteln (11a, 15a) genau zusammenzupassen,
die ersten und zweiten Ausrichtanordnungen (210, 210) und die ersten und zweiten Paßstifte derart angeordnet sind, daß sie die betreffenden ersten und zweiten Ausrichtstäbe berühren, wenn der elektrische Testkopf (11) mit Bezug auf den elektronischen Gerätesekundanten (15) in einem Versuch von deren Zusammendocken bewegt wird, bis die ersten und zweiten Paßstifte in den betreffenden ersten und zweiten Führungsöffnungen für eine präzise Ausrichtung der Ausrichtstäbe zwischen den Ausrichtanordnungen und den Paßstiften aufgenommen sind und dadurch das Andocken des elektronischen Testkopfes (11) und des elektronischen Gerätesekundanten (15) ermöglicht wird sowie das Zusammenpassen der ersten und zweiten Kontaktmittel (11a, 15a), und
die Höhe der ersten und zweiten Ausrichtanordnungen und die Höhe der ersten und zweiten Paßstifte aureichen, um einen Eingriff der ersten Kontaktmittel mit den zweiten Kontaktmitteln zu verhindern, bis eine präzise Ausrichtung erreicht ist, um eine Beschädigung der ersten und zweiten Kontaktmittel (11a, 15a) zu vermeiden.

2. Anlage zum Andocken und Entdocken eines elektrischen Testkopfes (11) mit Bezug auf einen elektronischen Gerätesekundanten (15), wobei der Testkopf und der Gerätesekundant erste und zweite elektrische Kontaktmittel (11a, 15a) aufweist, die für ein wechselseitiges Zusammenpassen ausgebildet sind, gekennzeichnet durch das Vorsehen von:
wenigstens ersten und zweiten Ausrichtstäben (202a, b), die erste und zweite Führungsöffnungen (204a, b) haben und an dem Gerätesekundanten (15) auf jeder Seite der zweiten elektrischen Kontaktmittel (15a) starr befestigt sind,
wenigstens erste und zweite Paßstifte (11b, 11b), die an dem Testkopf auf jeder Seite der ersten elektrischen Kontaktmittel (11a) starr befestigt sind,
wenigstens erste und zweite Ausrichtanordnungen (210, 210), die mit Bezug auf die ersten und zweiten Paßstifte jeweils selektiv beabstandet sind;
wobei die ersten und zweiten Führungsöffnungen (204a, b) mit Bezug auf die und zur Aufnahme der betreffenden ersten und zweiten Paßstifte (11b, 11b) präzise ausgerichtet sind, damit die ersten und zweiten elektrischen Kontaktmittel (11a, 15a) genau zusammenpassen,
die ersten und zweiten Ausrichtanordnungen und die ersten und zweiten Paßstifte derart positioniert sind, daß sie die betreffenden ersten und zweiten Ausrichtstäbe berühren, wenn der elektrische Testkopf (11) mit Bezug auf den elektronischen Gerätesekundanten (15) in einem Versuch von deren Zusammendocken bewegt wird bis die ersten und zweiten Paßstifte in den betreffenden ersten und zweiten Führungsöffnungen aufgenommen werden, damit die Ausrichtstäbe zwischen den Ausrichtanordnungen und den Paßstiften präzise ausgerichtet werden, um das Andocken des elektronischen Testkopfes (11) und des elektronischen Gerätesekundanten (15) zu erlauben sowie das Zusammenpassen der ersten und zweiten Kontaktmittel (11a, 15a), und
die Höhe der ersten und zweiten Ausrichtanordnungen und die Höhe der ersten und zweiten Paßstifte ausreicht, um einen Eingriff der ersten Kontaktmittel mit den zweiten Kontaktmitteln zu verhindern, bis eine präzise Ausrichtung erreicht ist, um eine Beschädigung der ersten und zweiten Kontaktmittel (11a, 15a) zu vermeiden.

3. Anlage nach Anspruch 1 oder 2, bei welcher die ersten und zweiten Ausrichtstäbe (202a, b) jeweils eine äußere Längsseitenfläche haben,

7

der erste Paßstift (11b) von der ersten Ausrichtanordnung (212a) getrennt ist, um den ersten Ausrichtstab(202a) zwischen der betreffenden Seitenfläche und der ersten Führungsöffnung in einer geringen Entfernung zwischen beiden aufzunehmen,

der zweite Paßstift (11b) von der zweiten Ausrichtanordnung (212b) beabstandet ist, um den zweiten Ausrichtstab (202b) zwischen der betreffenden Seitenfläche und der zweiten Führungsöffnung in einer geringen Entfernung zwischen beiden aufzunehmen.

**4.** Anlage nach Anspruch 1 oder 2, bei welcher die Höhe der ersten und zweiten Paßstifte (11b) und der oberen Flächen der ersten und zweiten Ausrichtanordnung (212a, b) im wesentlichen gleich ist.

**5.** Anlage nach Anspruch 1, Bei welcher die ersten und zweiten Ausrichtanordnungen (210, 210) einen Nockenaufbau (210, 210) aufweisen, um den Kopf (11) und den Sekundanten (15) zusammenzuziehen und auseinanderzustoßen, wobei der Nockenaufbau wenigstens zwei Nocken (212a, b) aufweist, die mit dem Gerätesekundanten gekuppelt sind und für eine Aufnahme von Nochenfolgestiften (206a, b) ausgebildet sind, die an dem Testkopf befestigt sind.

**6.** Anlage nach Anspruch 2, bei welcher die ersten und zweiten Ausrichtanordnungen (210, 210) einen Nockenaufbau (210, 210) aufweisen, um den Kopf (11) und den Sekundanten (15) zusammenzuziehen und auseinanderzustoßen, wobei der Nockenaufbau wenigstens zwei Nocken (212a, b) aufweist, die mit dem Testkopf gekuppelt sind und für eine Aufnahme von Nockenfolgestiften (206a, b) ausgebildet sind, die an dem Sekundanten befestigt sind.

**7.** Anlage nach Anspruch 5 oder 6, bei welcher die beiden Nocken (212a, b) schraubenförmige Nuten (216a, b) für eine Aufnahme von Nockenfolgestiften und eine Kabeleinrichtung (214) für ein Zusammenkuppeln der Nocken haben, sodaß sie synchron drehen.

**8.** Anlage nach Anspruch 1 oder 2, bei welcher wenigstens ein Paßstift (11b) eine Einrichtung für eine Einstellung (207) der Position des Paßstiftes aufweist.

## Revendications

**1.** Système pour fixer et enlever une tête d'essai électronique (11) par rapport à un manipulateur (15) de dispositif électronique, avec la tête d'essai et le manipulateur de dispositif ayant des premier et second moyens de contact électrique (11a, 15a) respectifs adaptés pour s'accoupler l'un à l'autre, caractérisé en ce que sont prévus :
- au moins une première et une seconde broches d'alignement (11b, 11b) fixées rigidement au manipulateur de dispositif (15) sur l'un et l'autre des côtés du second moyen de contact électrique (15a),
- au moins une première et une seconde barres d'alignement (202a, b) ayant des première et seconde ouvertures respectives de guidage (204a, b) et étant fixées rigidement à la tête d'essai (11) sur l'un et l'autre des côtés du premier moyen de contact électrique (11a),
- au moins une première et une seconde structures d'alignement (210, 210), chacune écartée sélectivement par rapport aux première et seconde broches d'alignement ;
- les première et seconde ouvertures de guidage (204a, b) étant alignées avec précision par rapport à et pour recevoir les première et seconde broches d'alignement respectives (11b, 11b) pour l'accouplement précis des premier et second moyens de contact électrique (11a, 15a),
- les première et seconde structures d'alignement (210, 210) et les première et seconde broches d'alignement étant positionnées de telle façon qu'elles entrent on contact respectivement avec les première et seconde barres d'alignement lorsque la tète d'essai électronique (11) est déplacée par rapport au manipulateur (15) de dispositif électronique lorsqu'on cherche à les assembler jusqu'à ce les première et seconde broches d'alignement soient reçues dans les première et seconde ouvertures de guidage respectives pour un alignement précis des barres d'alignement entre les structures d'alignement et les broches d'alignement et pour permettre ainsi la fixation de la tête d'essai électronique (11) sur le manipulateur (15) de dispositif électronique et l'accouplement des premier et second moyens de contact (11a, 15a), et
- la hauteur des première et seconde structures d'alignement et la hauteur des première et seconde broches d'alignement étant suffisantes pour empêcher l'engagement des premiers moyens de contact avec les seconds moyens de contact jusqu'à ce qu'un alignement précis soit réalisé pour éviter la dégradation des premier et second moyens de contact (11a, 15a).

**2.** Système pour fixer et enlever une tête d'essai électronique (11) par rapport à un manipulateur (15) de dispositif électronique, avec la tête d'essai et le manipulateur de dispositif ayant des premier et second moyens de contact électriques (11a, 15a) respectifs adaptés pour s'accoupler l'un à l'autre, caractérisé en ce que sont prévus :
- au moins des première et seconde barres d'alignement (202a, b) ayant des première et seconde ouvertures de guidage respectives (204a, b) et étant rigidement fixées au manipulateur de dispositif (15) sur l'un et l'autre des côtés du second moyen de contact électrique (15a),
- au moins des première et seconde broches d'alignement (11b, 11b) rigidement fixées à la tête d'essai sur l'un et l'autre des côtés du premier moyen de contact électriques (11a),
- au moins une première et une seconde structures d'alignement (210, 210) chacune étant écartée sélectivement par rapport aux première et seconde broches d'alignement ;
- les première et seconde ouvertures de guidage (204a, b) étant alignées avec précision par rapport à et pour recevoir les première et seconde broches d'alignement respectives (11b, 11b) pour un accouplement précis des premier et second moyens de contact électrique (11a, 15a),
- les première et seconde structures d'alignement et les première et seconde broches d'alignement étant positionnées de telle façon qu'elles entrent en contact respectivement avec les première et seconde barres d'alignement lorsque la tête d'essai électronique (11) est déplacée par rapport au manipulateur (15) de dispositif électronique lorsque l'on cherche à les assembler jusqu'à ce que les première et seconde broches d'alignement soient reçues dans les première et seconde ouvertures de guidage respectives pour un alignement précis des barres d'alignement entre les structures d'alignement et les broches d'alignement et pour permettre ainsi la fixation de la tête d'essai électronique (11) et du manipulateur (15) de dispositif électronique et l'accouplement des premier et second moyens de contact (11a, 15a), et
- la hauteur des première et seconde structures d'alignement et la hauteur des première et seconde broche d' alignement étant suffisantes pour empêcher l'engagement des premiers moyens de contact avec les seconds moyens de contact jusqu'à ce qu'un alignement précis soit obtenu pour empêcher la dégradation des premier et second moyens de contact (11a, 15a).

**3.** Système selon les revendications 1 ou 2 dans lequel lesdites première et seconde barres d'alignement (202a, b) ont chacune une surface latérale externe allongée,
- la première broche d'alignement (11b) étant séparée de la première structure d'alignement (212a) pour recevoir avec un faible écart entre elles la première barre d'alignement (202a) entre la surface latérale respective et la première ouverture de guidage,
- la seconde broche d'alignement (11b) étant espacée de la seconde structure d' alignement (212b) pour recevoir selon un faible écartement entre elles la seconde barre d'alignement (202b) entre la surface latérale respective et la seconde ouverture de guidage.

**4.** Système selon les revendications 1 ou 2 dans lequel la hauteur des première et seconde broches d'alignement (11b) et les surfaces supérieures des première et seconde structures d'alignement (212a, b) respectives sont sensiblement les mêmes.

**5.** Système selon la revendication 1 dans lequel les première et seconde structures d'alignement (210, 210) comprennent un ensemble d'adaptation (210, 210) pour tirer ensemble et pousser à l'écart l'un de l'autre la tête (11) et le manipulateur (15), ledit ensemble d'adaptation comprenant au moins deux cames (212a, b) couplées au manipulateur de dispositif et adaptées pour recevoir des broches suiveuses de came (206a, b) fixées à la tête d'essai.

**6.** Système selon la revendication 2 dans lequel les première et seconde structures d'alignement (210, 210) comprennent un ensemble d'adaptation (210, 210) pour tirer ensemble et pousser à l'écart l'un de l'autre la tête (11) et le manipulateur (15), ledit ensemble d'adaptation comprenant au moins deux cames (212a, b) couplées à la tète d'essai et adaptées pour recevoir des broches suiveuses de came (206a, b) fixées au manipulateur.

**7.** Système selon les revendications 5 ou 6 dans lequel lesdites deux cames (212a, b) ont des rainures hélicoïdales (216a, b) pour recevoir des broches suiveuses de came, et des moyens de câble (214) pour coupler les cames l'une avec l'autre de façon qu'elles tournent en synchronisme.

**8.** Système selon les revendications 1 ou 2 dans lequel au moins l'une desdites broches d'alignement (11b) comprend des moyens pour ajuster (207) la position de la broche d'alignement.

FIG.1

FIG. 2

FIG. 3

**FIG. 4**

**FIG. 5A**

**FIG. 6**

14

FIG. 5B

FIG. 5C